# EUROPEAN PATENT SPECIFICATION

(11) **EP 0 575 948 B1**
(45) Date of publication and mention of the grant of the patent: **23.04.1997**
(21) Application number: 93109905.5
(22) Date of filing: 22.06.1993
(51) Int. Cl.: H03H 9/05, H03H 3/02

(54) **Quartz device and manufacturing method thereof**
Quartzgerät und Verfahren zur Herstellung
Dispositif à quartz et méthode pour sa fabrication

(30) Priority: 23.06.1992 JP 164451/92; 23.06.1992 JP 164452/92; 01.07.1992 JP 174014/92; 03.07.1992 JP 176605/92
(43) Date of publication of application: 29.12.1993
(73) Proprietor: MATSUSHITA ELECTRIC INDUSTRIAL CO., LTD., Kadoma-shi, Osaka-fu, 571 (JP)
(72) Inventor: Kanaboshi, Akihiro, Neyagawa-shi, Osaka-fu 572 (JP); Ogura, Tetsuyoshi, Osaka-shi, Osaka-fu 532 (JP); Taguchi, Yutaka, Settsu-shi, Osaka-fu 566 (JP); Eda, Kazuo, Nara-ken 631 (JP)
(74) Representative: Eisenführ, Speiser & Partner

(56) References cited:
- EP-A- 0 156 146
- EP-A- 0 531 985
- FR-A- 2 458 150
- 1989 IEEE SOS/SOI TECHNOL. CONF. OCT 3-5, 1989 ; pp. 125-126; NEVADA (US)

## Description

### BACKGROUND OF THE INVENTION

### 1. Field of the Invention

The present invention relates to a quartz device and to a manufacturing method therefor.

### 2. Description of the Prior Art

Quartz devices, such as quartz oscillators and quartz filters, have become an essential component in modern data communications because of their extremely high stability. With the advancement of satellite communications, cellular telephones, and other communications devices, device miniaturization combined with improved performance has become a major developmental objective. This is equally true of quartz devices.

Strict frequency stability is essential to any quartz device. Because the frequency of the quartz device varies with the stress applied to the quartz plate, various measures have been used to reduce the stress applied to the quartz plate. For example, in the case of a chip-type quartz device, the quartz plate is fixed with a conductive adhesive to a metallic holding member having a flexible construction inhibiting the application of stress with the complete assembly sealed in a housing in a vacuum or with an inert gas to maintain long-term frequency stability. However, the frequency stability of this construction as the temperature varies is poor because stress applied to the quartz plate as a result of the difference in the thermal expansion coefficients of the metallic holding member, conductive adhesive, and quartz plate cannot be avoided.

Other problems also arise from the use of a conductive adhesive. First, because the adhesive area must be minimized in order to reduce the affect of the adhesive on quartz oscillation, this construction suffers from low mechanical strength and resistance to drops and impact shock. Because of the low heat resistance of the conductive adhesive, the conditions under which the quartz device can be soldered to a circuit board are extremely limited. In addition, the gases emitted during curing of the conductive adhesive are also emitted after sealing the structure, and contribute to deterioration of long-term frequency stability.

Furthermore, the relationship between the position of the quartz plate and the quartz device housing is limited because a space must be provided for applying the adhesive, and a large gap must be provided between the quartz plate and housing to reduce the change in the oscillation frequency with the generation of thermal stress from the difference in thermal expansion coefficients. Even if the size of the quartz plate itself can be reduced, miniaturization of the complete quartz device (including the housing) is extremely difficult.

A method for holding the quartz plate by means of a quartz holding member has been proposed (Japanese patent laid-open number 1990-291710) for the purpose of alleviating the stress applied to the quartz plate by the difference in thermal expansion coefficients. In this method, the quartz vibration member is held to the substrate by a quartz holding member with the direction securing the base and the quartz holding member perpendicular to the direction securing the quartz holding member and quartz vibration member. This suppresses the frequency change resulting from stress caused by a change in the temperature applied to the quartz vibration member.

However, even this method cannot ignore the effects of the thermal expansion coefficient of the conductive adhesive securing the quartz vibration member and quartz holding member, and the frequency stability as the temperature changes is insufficient. For this method to be sufficiently effective, the adhesive area of the adhesive and the conductive adhesive must in principle also be small, resulting in problems with adhesive strength. In addition, the problems caused by gases emitted during adhesive curing described above still remain. As a result, this method cannot be considered to be a sufficient solution.

While applied quartz device products include quartz oscillators, temperature correction quartz oscillators (TCXO), and voltage control quartz oscillators (VCXO), miniaturization has also become a major developmental objective for these products. The quartz devices and control circuits driving the quartz devices used in these products are separately manufactured, assembled, and sealed in a housing. As a result, miniaturizing the complete assembly is still difficult.

It is possible to present a one chip type quartz oscillator, TCXO or VCXO, if it is possible to incorporate a quartz plate to the semiconductor substrate having an IC control circuit. However, the frequency stability of the quartz can be obtained only by preparing the quartz in special steps involving predetermined cutting angle and the crystallization of the single crystal quartz. It is not possible to present a thin plate, single crystalline quartz with a desired crystallization direction by applying the quartz according to the conventional deposition or sputtering.

Other than quartz, aluminum nitride (AlN) and zinc oxide (ZnO) are known as thin plate material having piezoelectric properties, the piezoelectric devices using thin plate made by these materials are not appropriate for the use in the communication devices due to poor quality factor Q and frequency stability, when compared with those of the quartz.

Therefore, the frequency stability - temperature characteristic of a conventional quartz device as described above is impaired because the quartz plate is attached by means of metallic members and adhesives having thermal expansion coefficients different from that of the quartz plate. Other problems with the prior art as described above include low mechanical strength and resistance to dropping and impact shock because the quartz plate is attached with adhesive, reliability problems caused by the heat of soldering, and deterioration of long-term frequency stability resulting from gases emitted from the adhesive inside the sealed housing. There are also fundamental problems relating to the miniaturization of the quartz device and applied quartz device products caused by the structure of the quartz device.

Therefore, the object of the present invention is to improve the quartz device characteristics, particularly the frequency stability - temperature characteristic, mechanical strength characteristic, reliability after heating, and long-term frequency stability, and to simplify the miniaturization of the quartz device and applied quartz device products.

### SUMMARY OF THE INVENTION

To achieve this object, a quartz device according to the present invention is characterized by a structure wherein the quartz plate is attached by direct bonding to the holding member, or the quartz plate is attached by direct bonding to the holding member and the holding member is attached by direct bonding to the housing substrate.

In both of the above cases, the holding member directly connected to the quartz plate is made of a material having a thermal expansion coefficient equal to or nearly equal to that of the quartz plate.

When the quartz plate is attached by the holding member to the housing substrate, the holding member structure is characterized by inhibiting the transmission of stress from the housing substrate to the quartz plate.

In the manufacturing method for this quartz device, the surfaces of the quartz plate and holding member, or the quartz plate, holding member, and housing substrate, are hydrophilically treated, the surfaces placed in contact, and heat treatment is applied to induce direct bonding between the surfaces.

Alternatively, the surfaces of the quartz plate and holding member, or the quartz plate, holding member, and housing substrate, are washed, the surfaces placed in contact, and a voltage is applied to the interfaces for anodic bonding forming a direct bond between the surfaces.

With a quartz device thus constructed, there is virtually no stress caused by temperature acting on the quartz plate and holding member because the holding member directly connected to the quartz plate is of a material having a thermal expansion coefficient equal to or nearly equal to that of the quartz plate. When the holding member is attached to the housing substrate, the stress acting on the quartz plate is minimal, the change in the frequency due to stress caused by temperature changes can be minimized, and frequency stability can be improved because virtually all stress due to temperature change is concentrated on the holding member.

Because the quartz plate is attached by direct bonding without using adhesive, the adhesion strength is strong, and mechanical strength and resistance to dropping and impact shock is improved. The heat stability characteristic and reliability after heating are also improved. Long-term frequency stability is also improved because there are no gas emissions from an adhesive.

Miniaturization of the quartz plate, holding member, or housing substrate is also simplified by applying semiconductor processing technologies enabling extremely precise dimensional processing.

An airtight seal is formed around the quartz plate to improve long-term frequency stability. When the quartz plate is effectively sealed airtight by a holding member of a material with the same thermal expansion coefficient, the change in the oscillation frequency resulting from stress induced by a temperature change applied from the housing to the quartz plate can be significantly reduced, and frequency stability can be improved, compared with a construction in which the quartz plate is sealed by a housing of a material with a different thermal expansion coefficient.

### BRIEF DESCRIPTION OF THE DRAWINGS

The present invention will become more fully understood from the detailed description given below and the accompanying diagrams wherein:
Fig. 1a is a perspective view of a quartz device according to the first embodiment of the invention,
Figs. 1b to 1d are exploded view, perspective view and cross-sectional view, respectively, showing a modification of the first embodiment,
Figs. 2a, 2b and 2c are cross-sectional view, perspective view without a cover substrate, and perspective view with a cover substrate, respectively, showing a quartz device according to the second embodiment of the invention,
Figs. 2d to 2f are cross-sectional view, perspective view without a cover substrate, and perspective view with a cover substrate, respectively, showing a modification of the second embodiment,
Figs. 3a and 3b are perspective views without and with control circuit, showing a quartz device according to the third embodiment of the invention,
Fig. 4 is a perspective view of a quartz device according to the fourth embodiment of the invention,
Figs. 5a, 5b and 5c are cross-sectional view, perspective view without a cover substrate, and perspective view with a cover substrate, respectively, showing a quartz device according to the fifth embodiment of the invention,
Figs. 6a to 6e are cross-sectional views showing the steps for manufacturing a quartz device shown in Figs. 1b to 1c, and
Figs. 7a to 7f are cross-sectional views showing the steps for manufacturing a quartz device according to the third embodiment of the invention.

### DETAILED DESCRIPTION OF THE PREFERRED EMBODIMENTS

### (First Embodiment)

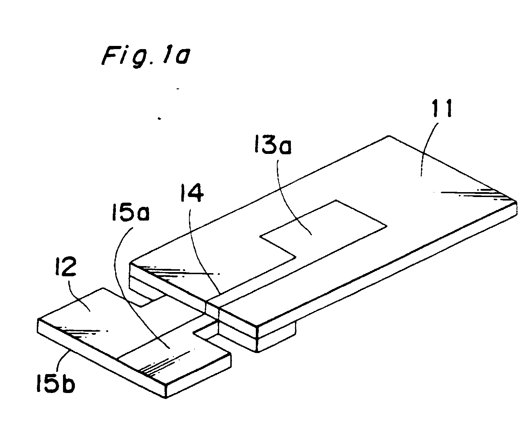

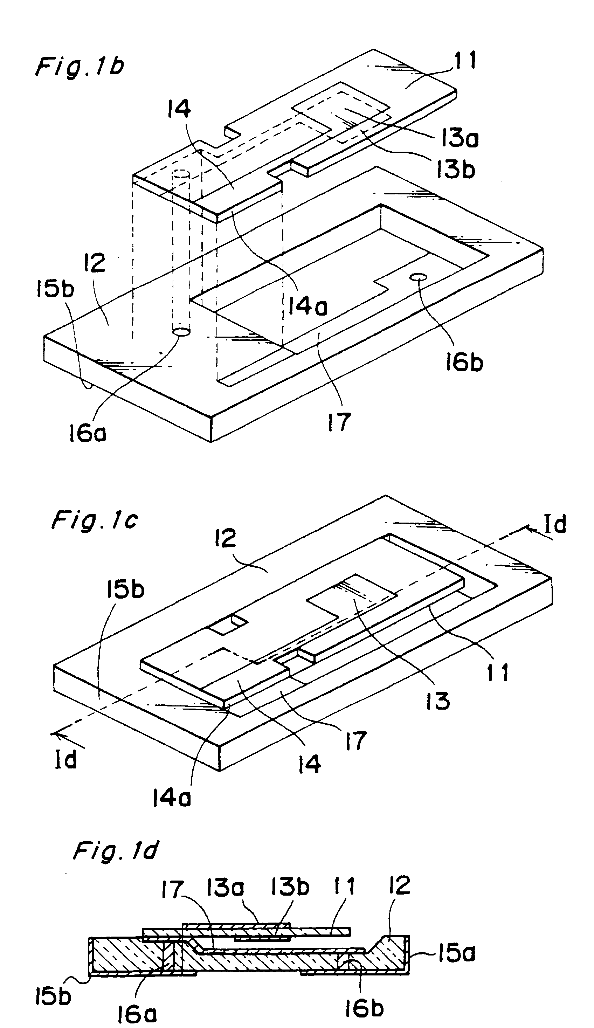

The first embodiment of a quartz device according to the present invention is described below with reference to the accompanying figures, of which Fig. 1a is an external view of this quartz device. As shown in this figure, the quartz device comprises a quartz plate 11 made of single crystal quartz, holding member 12 made of quartz, excitation electrode 13a, runner electrode 14, and terminal 15a. A counter electrode 13b, such as shown in Fig. 1b, is provided on the opposite surface of the quartz plate 11. A runner electrode extends from the counter electrode 13b and is electrically connected to terminal 15b through a pin electrode extending through a through hole provided in holding member 12 in a manner similar to that shown in Fig. 1d.

In this embodiment, the quartz plate 11 is an AT cut quartz blank measuring 40 µm thick, 3 mm long, and 2 mm wide. The holding member 12 is an H-shaped, AT cut quartz blank measuring 50 µm thick, 2 mm long, and 2 mm wide. Instead of AT cut, other cut, such as BT cut can be employed. The excitation electrode 13, runner electrode 14, and terminal 15 are each a 300 Å thick chrome vapor deposition film with a 3000 Å thick gold vapor deposition film coating.

The quartz plate 11 and the holding member 12 are attached at respective end portions by direct bonding in a manner that will not inhibit vibration of the quartz plate 11.

The direct bonding is described below. Direct bonding is a technology in which a silicon substrate, quartz plate, or glass plate are directly bonded by means of covalent bonding between the atoms in the free (unbonded) crystal surface of one substrate and the atoms in the crystal surface of another substrate.

There are two ways of obtaining a directly bonded interface.

The first method uses hydrophilic groups on the substrate surfaces by first polishing, washing, and treating the surfaces of the silicon substrate and quartz plate (or other members if applicable) to form hydrophilic groups on the surfaces thereof. The surfaces are then placed in contact in a clean atmosphere and, thereafter, heat treated to obtain a strong bond. The present embodiment is described below with respect to a manufacturing method using this first method. The adhesion strength of the direct bond interface obtained with this method is approximately several ten kgw/cm² in the initial stage when contact is made after hydrophilic group formation. This improves to several hundred kgw/cm² after heat treatment is applied. It is to be noted that the adhesion strength at the bonded interfaces is herein defined as "the limit value of the tensile stress at which the interfaces separate when tensile stress is applied perpendicular to the interface."

This bond is specifically formed as follows. After treating the substrates to be bonded to form hydrophilic groups on the surface, the substrates are bonded by the hydrogen bonds of the hydrophilic groups formed on the substrate surfaces and the hydrogen molecules at the adhesion interface during the initial bonding stage of simple contact between the substrate surfaces. The hydrogen molecules at this interface are removed by heat treatment, and the bond formed by the hydrogen molecules gradually changes to a strong covalent bond between the constituent atoms of the crystal. As a result of this direct bonding of the various members, adhesion strength is high, and no adhesives are used, resulting in strong resistance to heat treatment and vibration, and eliminating emission of unwanted gases often produced from adhesives.

The second method of obtaining a direct bond interface is anodic bonding. First, the silicon substrate and quartz plate are polished, cleaned, and placed in direct contact, and a voltage is then applied while heating the interface to bond the surfaces by electrostatic attraction. A quartz device with a direct bond interface and the same structure as that of the present embodiment manufactured with the first method described above was also obtained. As in the quartz device obtained with the first method, adhesion strength is high, and no adhesives are used, resulting in strong resistance to heat treatment and vibration, and eliminating emission of unwanted gases.

The temperature characteristics of the quartz device are determined by the cut angle of the quartz plate. In the case of an AT cut quartz plate, if the change (f-f0)/f0 in the frequency f at a given temperature relative to the frequency f0 at the reference temperature (normally 25°C) is expressed as ppm, the change in frequency f is normally ±5 ppm in the temperature range from -20°C to 70°C. However, in the case of a conventional quartz device, the actual temperature characteristic deteriorates because stress caused by temperature changes in the metallic holding member and conductive adhesive act on the quartz plate. In the case of a quartz device according to the present embodiment of the invention, however, the holding member 12 bonded to the quartz plate 11 has a thermal expansion coefficient equal to that of the quartz plate 11. The frequency-temperature characteristic is therefore greatly improved because there is virtually no temperature change-induced stress acting on the quartz plate.

This improvement was demonstrated by comparing a quartz device according to this embodiment with a conventional quartz device manufactured to the same shape as the present embodiment (40 µm thick, 3 mm long, and 2 mm wide) with an excitation electrode evaporated on the quartz plate. An improvement of 12 ppm in the frequency-temperature characteristic through the range from -20°C to 70°C was observed with the quartz device of the invention. This improvement is a result of using a quartz with an equal thermal expansion coefficient as the holding member, and because thermal stress caused by a difference in the thermal expansion coefficients of the quartz and adhesive does not occur because an adhesive is not used.

It is to be noted that because quartz is an anistropic crystal, the thermal expansion coefficient will vary relative to the crystal axis. It follows that if the crystal axis of the quartz plate 11 is aligned with the crystal axis of the holding member 12, the thermal expansion coefficients of the quartz plate 11 and holding member 12 at the bond will be precisely matched, and stress from temperature changes will be zero, i.e., nonexistent. Because the quartz plate 11 can essentially be freely configured, a nearly ideal frequency-temperature characteristic can be obtained.

The improvement obtained by crystal axis alignment was further demonstrated by manufacturing a quartz device configured as described above but with the crystal axes of the quartz plate 11 and holding member 12 aligned prior to direct bonding. A further improvement of 2 ppm in the frequency-temperature characteristic through the range from -20°C to 70°C was observed when compared with the quartz device according to the invention described above, resulting in a 14 ppm improvement relative to the conventional quartz device.

It is to be noted that the use of direct bonding to hold the quartz plate in this embodiment also results in improved mechanical strength determined by resistance to dropping and impact shock compared with quartz devices manufactured using a conductive or other type of adhesives. Because of the thermal stability of the direct bond interface, reliability with heating is improved. In addition, the long-term frequency stability after sealing in a housing is also improved because there are no unwanted gases released from a conductive adhesive.

It is to be further noted that while quartz is selected as the holding member material in this embodiment, the holding member shall not be so limited, and in principle any material with a thermal expansion coefficient equal to or nearly equal to the thermal expansion coefficient of quartz can also be used. One specific example of such a material is flint glass.

The thermal expansion coefficient of AT cut quartz plate is approximately 9x10⁻⁶ in the greatest direction. The thermal expansion coefficient of a flint glass plate is 8.9x10⁻⁶, or nearly equal to that of AT cut quartz plate. If a glass with a thermal expansion coefficient equal to or nearly equal to the thermal expansion coefficient of the quartz plate 11 is used as the holding member, there will be virtually no stress due to temperature change at the bond between the quartz plate 11 and the holding member. As a result, the same practical effects obtained by the present embodiment can be obtained.

To demonstrate this, a quartz device shaped as described above but manufactured using a type of flint glass with a thermal expansion coefficient of 8.9x10⁻⁶ as the material of the holding member 12 was prepared. An improvement of 10 ppm in the frequency-temperature characteristic through the range from -20°C to 70°C was observed with this quartz device relative to the conventional quartz device. The additional benefits of lower cost and relatively simple processability, including etching, are also obtained with a glass holding member simply because the material is glass.

### (Modification)

It is also not necessary for the holding member to be smaller than the quartz plate, and, for example, the quartz plate can be mounted on the holding member of a vessel shape, as will be explained in a modification below.

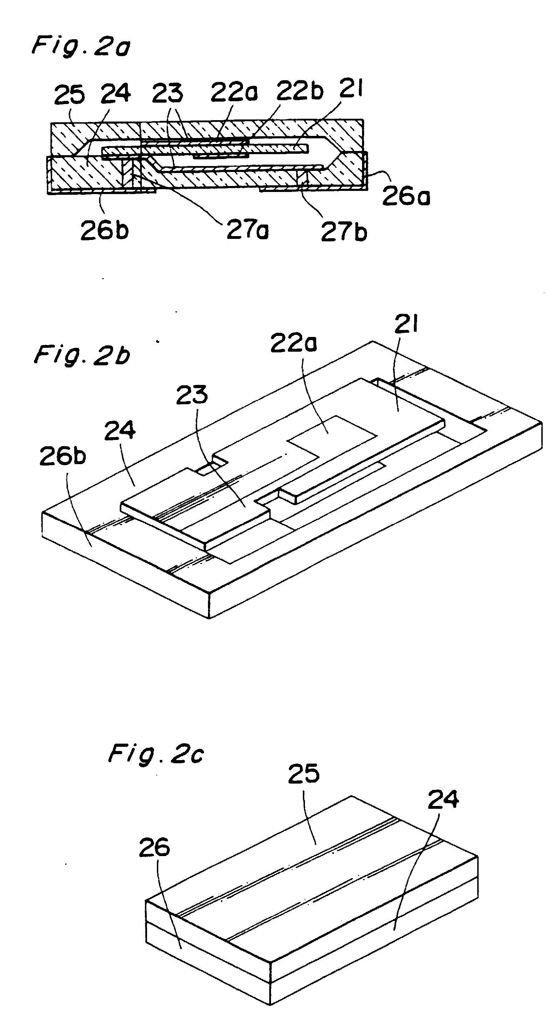

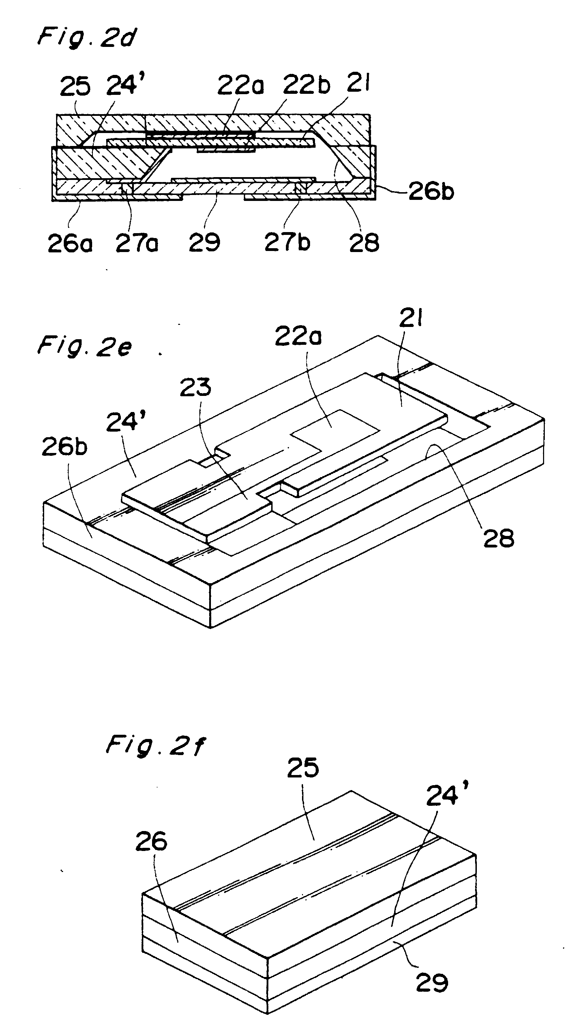

Referring to Figs. 1b to 1d, a modification of the first embodiment is shown. The device comprises quartz plate 11, vessel shaped holding member 12 having a recess at about the center thereof, excitation electrode 13a, runner electrode 14, terminal 15, and via holes 16. A counter electrode 13b is provided on the opposite surface of the quartz plate 11. A runner electrode also extends from the counter electrode 13b. The quartz plate 11 and holding member 12 are AT cut quartz plate, and the vessel shaped holding member 12 is sized sufficiently larger than the quartz plate 11 to enable placing of a cover member, such as shown in Fig. 2c, to form a practical airtight seal. The specific dimensions of the quartz plate 11 are 4 mm long and 2 mm wide, and the holding member 12 is 5 mm long and 3 mm wide with a recess depth of 0.5 mm. A portion of the quartz plate 11 is connected to the vessel shaped holding member 12 by direct bonding, and the major portion of the quartz plate 11 which is subject to the vibration hangs over the recess of the holding member 12.

The via holes 16a, 16b are pre-formed at suitable positions through the holding member 12 and used to provide electrodes to pass therethrough. Specifically, the excitation electrode 13b laminated on the lower surface of the quartz plate 11 is extended and is connected to an electrode passing through the via hole 16a and is further connected to terminal 15b, as best shown in Fig. 1d. Similarly, the excitation electrode 13a laminated on the upper surface of the quartz plate 11 is extended along runner electrode 14, and then to a side electrode 14a and further to anther runner electrode 17. The electrode 17 is connected to an electrode passing through the via hole 16b and is further connected to terminal 15a, as shown in Fig. 1d.

Instead of the recess, it is possible to form an open through hold in the holding member 12, such as in a manner shown in Fig. 2d.

It will be obvious that the same effects described above are obtained with these devices. In addition, the new benefit of the quartz plate 11 becoming more resistant to damage is obtained because the quartz plate 11 is mounted on the holding member 12.

### (Second Embodiment)

The second embodiment of a quartz device according to the present invention is described below with reference to the accompanying Figs. 2a to 2c. Fig. 2a is a cross-section view, Fig. 2b is an internal view, and Fig. 2c is an external view of the quartz device. As shown in Figs. 2a to 2c, the quartz device comprises a quartz plate 21 made of quartz, holding member 24 made of quartz, excitation electrodes 22a and 22b, runner electrodes 23, cover substrate 25, terminals 26a and 26b, and via holes 27a and 27b.

In this embodiment, the holding member 24 holds the quartz plate 21, and also functions as the housing substrate forming an airtight seal with the cover substrate 25. Preferably, both the holding member 24 and cover substrate 25 are made of quartz. The quartz plate 21 is directly bonded to the holding member 24, which has a recessed center, and the holding member 24 is directly bonded to the cover substrate 25, which also has a recessed center, thereby forming an airtight seal around the quartz device housed inside. As a result, thermal stress resulting from adhesion between the quartz plate 21 and a non-quartz material cannot act on the quartz plate 21. In addition, by pulling the runner electrode 23 to the outside through the via holes 27a and 27b, this construction also eliminates the use of adhesives in the quartz device.

### (Modification)

Referring to Figs. 2d to 2f, a modification of the second embodiment is shown.

When compared with the quartz device of Fig. 2a to 2c, the quartz device of this modification has a holding member 24' formed with an opening 28 at position where the recess was formed. Furthermore, a bottom substrate 29 made of quartz is provided. As shown in Fig. 2d, the edge of the holding member 24' connected to the quartz plate 21 has an acute angle so that the runner electrode extending from the excitation electrode 22b to the inner surface of the opening 28 can be deposited without any disconnection.

In addition to the benefits described with respect to the first embodiment above, the additional benefit of making the overall size of this quartz device extremely small is also obtained by thus forming an airtight seal by direct bonding of the holding member and cover substrate. In a conventional quartz device using a quartz plate measuring 3 mm long by 1 mm wide, the overall size, including the housing, is 8 mm long and 4 mm wide, the maximum size reduction possible. Using a quartz plate of equal dimensions in the present embodiment, however, the overall quartz device size is only 5 mm long by 3 mm wide, less than 47% of the total area of the conventional quartz device. There are two reasons for this size reduction.

First, the space required to apply the adhesive in the conventional device is reduced to a small space by using direct bonding. Second, while a gap between the adhesive member and the vibrating member must be provided in the conventional quartz device to reduce the change in the oscillation frequency accompanying thermal stress resulting from the thermal expansion coefficient difference, thermal stress does not occur in this embodiment as a result of direct bonding of materials with equal thermal expansion coefficients in this quartz device, and this gap can therefore be eliminated.

It is to be further noted that while quartz is selected as the material of the holding member and the cover substrate in this embodiment, these materials shall not be so limited, and in principle any material with a thermal expansion coefficient equal to or nearly equal to the thermal expansion coefficient of quartz can also be used for at least the material of the holding member.

To demonstrate this, a quartz device shaped as described above but manufactured using a type of flint glass with a thermal expansion coefficient of 8.9x10⁻⁶ as the material of the holding member and the cover substrate was prepared. While the other effects of this embodiment were obviously obtained, the additional benefits of lower cost and relatively simple processability, including etching, are also obtained because of the type of material used.

### (Third Embodiment)

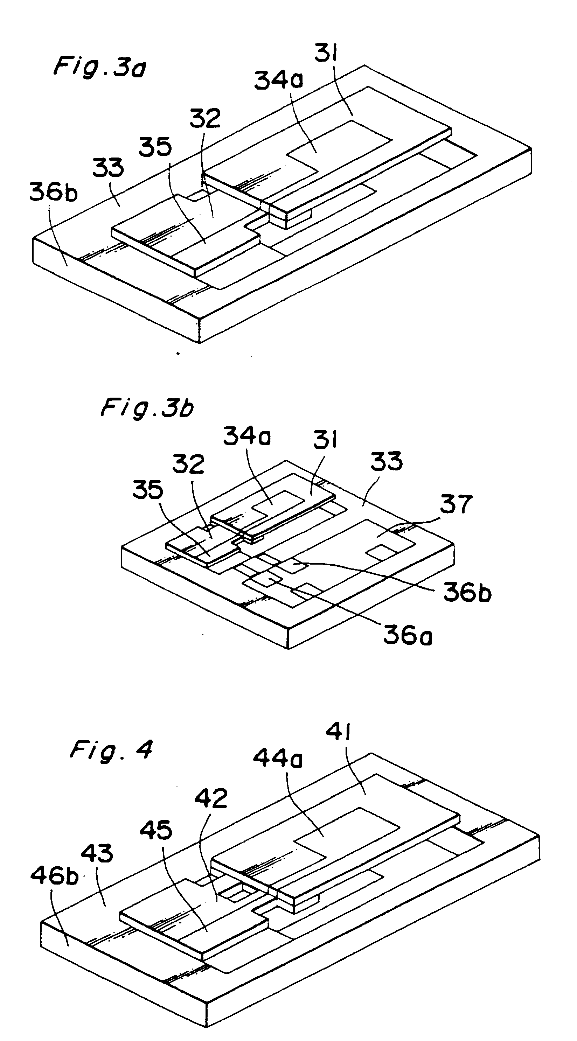

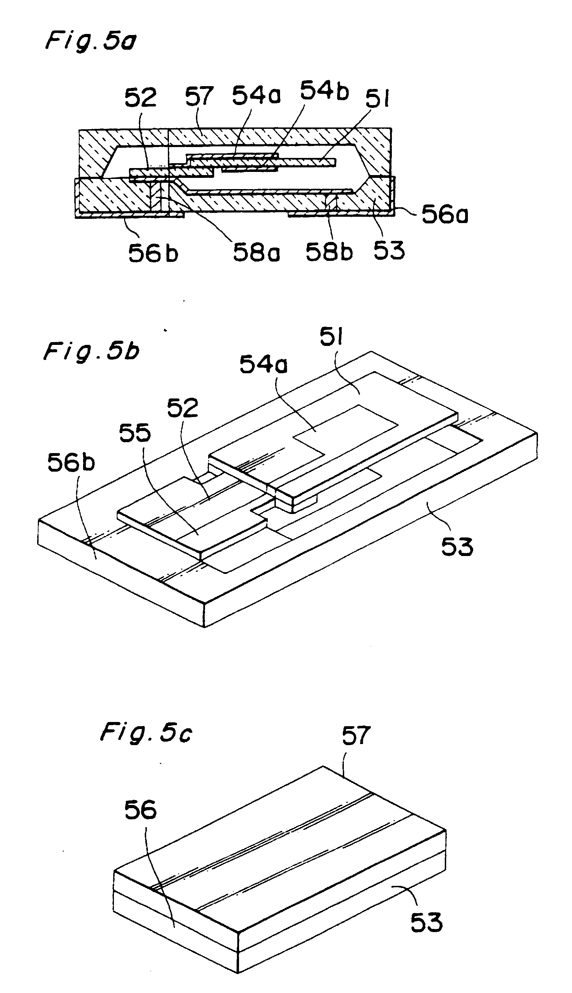

The third embodiment of a quartz device according to the present invention is described below with reference to the accompanying figures, of which Fig. 3a is an external view of this quartz device. As shown in this figure, the quartz device comprises a quartz plate 31, holding member 32, vessel shaped housing substrate 33 having a recess at about the center thereof, excitation electrodes 34a and 34b, runner electrode 35, and terminals 36a and 36b. The vessel shaped housing substrate 33 is sized sufficiently larger than the quartz plate 31 to enable placing of a cover member, such as shown in Fig. 5c, to form a practical airtight seal. A portion of the quartz plate 31 is connected to a portion of holding member 32, and another portion of holding member 32 is connected to a portion of the vessel shaped housing substrate 33 adjacent the recess, and the major portion of the quartz plate 31 which is subject to the vibration hangs over the recess of the housing substrate 33. The connections between the portion of the quartz plate 31 and the portion of holding member 32, and between the portion of holding member 32 and the portion of the vessel shaped housing substrate 33 are done by direct bonding.

In this embodiment, the holding member 32 is quartz and the housing substrate 33 is silicon. Part of the periphery of the quartz plate 31 is attached by direct bonding to the holding member 32 in a manner that will not inhibit vibration of the quartz plate 31, and the part of the holding member 32 to which the quartz plate 31 is not attached is connected to the housing substrate 33 by direct bonding. The excitation electrodes are connected to the terminals through the via holes as described in the alternative construction of the first embodiment above.

The quartz plate 31, holding member 32, and housing substrate 33 are configured to inhibit the application of stress caused by ambient temperature changes from acting on the quartz plate 31. Specifically, the width of the holding member 32 is narrower than the width of the quartz plate 31.

Because both the quartz plate 31 and holding member 32 are quartz in this embodiment, virtually no temperature change-related stress occurs at the bond between the quartz plate 31 and holding member 32. Stress due to the difference in the thermal expansion coefficients of the housing substrate 33 and quartz plate 31 is nearly all concentrated on the holding member 32, thus inhibiting the transmission of stress from the housing substrate 33 to the quartz plate 31. Change in the frequency due to stress caused by temperature changes can therefore be suppressed to an extremely low level, and the frequency stability characteristic of the quartz device is improved.

This improvement was demonstrated by comparing a quartz device according to this embodiment with a conventional quartz device manufactured to the same shape (3 mm long, and 1 mm wide) with an excitation electrode evaporated on the quartz plate. An improvement of 9 ppm in the frequency-temperature characteristic through the range from -20°C to 70°C was observed with the quartz device of the invention.

The use of direct bonding to hold the quartz plate in this embodiment also results in improved mechanical strength determined by resistance to dropping and impact shock compared with quartz devices manufactured using a conductive or other type of adhesive. Because of the thermal stability of the direct bond interface, reliability with heating is improved. In addition, the long-term frequency stability after sealing in a housing is also improved because there are no unwanted gases released from a conductive adhesive.

Because this structure further comprises the holding member between the quartz plate and housing substrate, the quartz plate and housing substrate can be directly bonded through the holding member even when the thermal expansion coefficients of the quartz plate and housing substrate differ, and the new effect of a greater degree of freedom in the selection of housing substrate materials is obtained.

For example, if the housing substrate 33 is a semiconductor substrate, the circuitry for driving and controlling the quartz plate can be integrated in the device, and a single chip quartz oscillator, TCXO, VCXO, or other applied quartz device product can be manufactured. The external view of a single chip quartz oscillator is shown in Fig. 3b. This device comprises a quartz plate 31, holding member 32, housing substrate 33, excitation electrode 34, runner electrode 35, terminal 36, and control circuit 37, such as an IC circuit. By using a silicon housing substrate and forming the oscillation circuit in part of the housing substrate according to the present embodiment, the quartz plate directly bonded to the housing substrate through the holding member can be oscillated by this oscillation circuit.

If the housing substrate 33 is a glass substrate, processing the housing substrate 33 is easier and the cost can also be reduced.

It is to be further noted that while quartz is selected as the holding member material in this embodiment, the holding member shall not be so limited, and in principle any material with a thermal expansion coefficient equal to or nearly equal to the thermal expansion coefficient of quartz can also be used. This is as described in the first embodiment above.

While the orientation of the crystal axes of the quartz in the quartz plate and holding member has not been discussed above, these crystal axes are preferably aligned as was described in the first embodiment above.

### (Fourth Embodiment)

The fourth embodiment of a quartz device according to the present invention is described below with reference to the accompanying figures, of which Fig. 4 is an external view of this quartz device. As shown in this figure, the quartz device comprises a quartz plate 41, holding member 42, housing substrate 43, excitation electrodes 44a and 44b, runner electrode 45, and terminals 46a and 46b.

In this embodiment, the holding member 42 is quartz. The overall construction is the same as that of the third embodiment except that the holding member 42 is processed to a shape enabling easier elastic deformation. Specifically, a recess is formed at approximately the middle of the part not directly bonded to the quartz plate 41 and housing substrate 43, and the quartz plate 41 is supported by two cross members. As a result of this construction, the stress due to a difference in the thermal expansion coefficients of the housing substrate 43 and holding member 42 is virtually all alleviated by deformation of the holding member 42, and virtually no stress is applied from the housing substrate 43 to the quartz plate 41. The effect of minimizing any change in oscillation frequency due to stress caused by temperature changes is further improved compared to the third embodiment, and the frequency stability characteristic is therefore further improved. A real improvement of 2 ppm in the frequency-temperature characteristic of this embodiment compared with the third embodiment, and 11 ppm compared with the conventional quartz device, was observed.

It is to be further noted that while quartz is selected as the holding member material in this embodiment, the holding member shall not be so limited, and in principle any material with a thermal expansion coefficient equal to or nearly equal to the thermal expansion coefficient of quartz can also be used. This is as described in the first embodiment above.

While the orientation of the crystal axes of the quartz in the quartz plate and holding member has not been discussed with respect to this embodiment, these crystal axes are preferably aligned as was described in the first embodiment above.

### (Fifth Embodiment)

The fifth embodiment of a quartz device according to the present invention is described below 5 reference to the accompanying Figs. 5a to 5c. Fig. 5a is a cross section, Fig. 5b is an internal view, and Fig. 5c is an external view of this quartz device. As shown in Figs. 5a to 5c, the quartz device comprises a quartz plate 51, holding member 52, housing substrate 53, excitation electrode 54a and 54b, runner electrode 55, terminals 56a and 56b, cover substrate 57, and via holes 58a and 58b.

In this embodiment, the holding member 52 is quartz. The quartz plate 51, holding member 52, housing substrate 53, excitation electrode 54 and other components are configured identically to those of the quartz device according to the third embodiment.

The quartz plate 51 and holding member 52, holding member 52 and housing substrate 53, and the housing substrate 53 and cover substrate 57, which has a recessed center, respectively, are directly bonded, thus forming an airtight seal around the inside of the quartz device. As a result, thermal stress resulting from adhesion between the quartz plate 51 and a non-quartz material cannot act on the quartz plate 51. In addition, by pulling the runner electrode 55 to the outside through the via holes 58, this construction also eliminates adhesives in the quartz device.

In addition to the benefits described with respect to the third embodiment above, the additional benefit of making the overall size of this quartz device extremely small is also obtained by thus forming an airtight seal by direct bonding of the housing substrate and cover substrate. In a conventional quartz device using a quartz plate measuring 3 mm long by 1 mm wide, the overall size including the housing is 8 mm long and 4 mm wide, the maximum size reduction possible. Using a quartz plate of equal dimensions in the present embodiment, however, the overall quartz device size is only 6 mm long by 3 mm wide, approximately 56% of the total area of the conventional quartz device.

It is to be further noted that while quartz is selected as the holding member material in this embodiment, the holding member shall not be so limited, and in principle any material with a thermal expansion coefficient equal to or nearly equal to the thermal expansion coefficient of quartz can also be used. This is as described in the first embodiment above.

In addition, if the housing substrate 53 is a semiconductor substrate, single chip applied quartz devices can be easily manufactured as described in the third embodiment above. By additionally applying the present embodiment, however, the size of the single chip applied quartz device can easily be made extremely small. A specific example is described in comparison to a TCXO.

In a conventional TCXO, the quartz oscillator and the circuit components controlling and driving the quartz oscillator are separately manufactured and assembled in a single housing to form the device. The size of a conventional TCXO is therefore typically 18 mm long, 13 mm wide, and 5 mm high. By integrating the quartz oscillator and the circuit components controlling and driving the quartz oscillator, and directly bonding the housing substrate and cover substrate according to the present embodiment, however, the resulting device dimensions are 5 mm long, 4.5 mm wide, and 3 mm high, a mere 6% of the conventional device size.

If the housing substrate 53 and cover substrate 57 are additionally manufactured from a glass substrate, processing the housing substrate 53 and cover substrate 57 is easier, and the cost is further reduced.

While the orientation of the crystal axes of the quartz in the quartz plate and holding member has not been discussed with respect to this embodiment, these crystal axes are preferably aligned as was described in the first embodiment above.

In addition, while the seal of this quartz device is formed by the housing substrate, the invention shall not be so limited. This embodiment can be easily applied to other electronic components to form a seal with the same effects.

### (Sixth Embodiment)

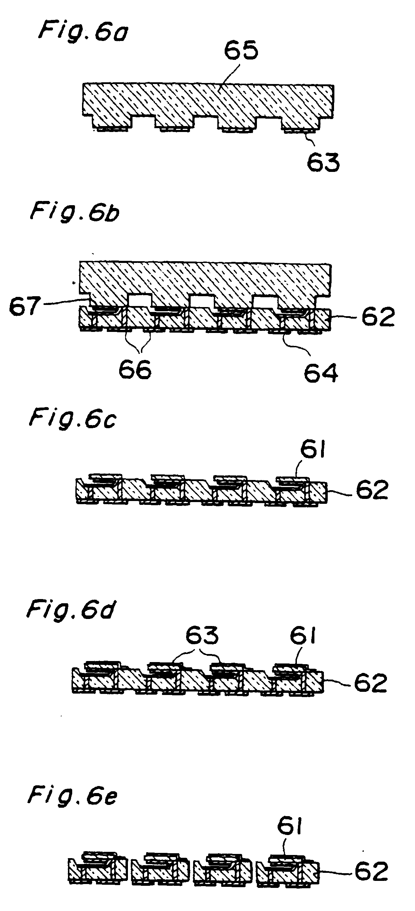

The sixth embodiment according to the present invention is described below with reference to Figs. 6a to 6e, illustrating the steps for manufacturing the quartz device of the modification of the first embodiment described above in connection with Figs. 1b-1d. Shown in Figs. 6a to 6e are the quartz plate 61 having plural rectangular projections, holding member bulk 62 having plural recesses at positions corresponding to the plural rectangular projections, excitation electrode 63, terminal 64, runner electrode 67, quartz wafer 65, and via holes 66.

In this manufacturing method, a 350 µm thick, 3 inch square AT cut quartz wafer is used for the quartz wafers 65 and for the holding member bulk 62.

The one quartz wafer 65 is mechanically lapped and etched to a 50 µm depth leaving plural rectangular projections 3 mm long and 1 mm wide which is a size equal to the size of the quartz plates 61. Thereafter, as shown in Fig. 6a, excitation electrode 63 and runner electrode are formed by vacuum vapor deposition of chrome and gold to a thickness of 200 Å and 500 Å, respectively.

For the direct bonding of holding member bulk 62 and the quartz wafer 65, the surface of the quartz wafer 65 is polished to a mirror finish. The polished surfaces are then treated to form hydrophilic groups using a solution of ammonia water, hydrogen peroxide, and water which are heated to 60°C, and then water washed. The surfaces are then carefully washed to remove any foreign matter on the contact surfaces of the quartz wafer 65 and holding member bulk 62. The holding member bulk 62 and the quartz wafer 65 are then placed in contact with each other with the surfaces still in a clean state so as to connect the quartz wafer 65 and the holding member bulk 62 by direct bonding effected between a portion of each of the rectangular projections and a portion adjacent each of the recesses. At this point, the holding member bulk 62 and the quartz wafer 65 are carefully positioned to make an electric contact between runner electrode and terminal 64 through the electrode provided in the via hole 66.

While a fairly high adhesion strength is obtained in this state alone, heat treatment is applied to increase the adhesion strength to a level permitting subsequent lapping (grinding). This state is shown in Fig. 6b.

It is to be noted that the crystal transition temperature of quartz is 870°C, and the piezoelectric properties of the quartz will be lost when the wafers cool to room temperature if the heat treatment temperature exceeds 870°C. The heat treatment temperature, therefore, cannot exceed 870°C. The heat treatment temperature is thus set at, for example, 500°C in this embodiment.

To separate the individual quartz plate 61, the quartz wafer 65 directly bonded to the holding member bulk 62 is lapped while holding the holding member bulk 62 to form the quartz plate 61, as shown in Fig. 6c.

The excitation electrode 63 and runner electrode are then formed on the quartz plate 61. The excitation electrodes 63 and runner electrodes 65 are formed by vacuum vapor deposition of chrome and gold to a thickness of 200 Å and 500 Å, respectively. This is shown in Fig. 6d.

The holding member bulk 62 is then cut to separate the holding members, resulting in the quartz device structure described in the modification of the first embodiment above. This is shown in Fig. 6e.

The quartz plate 61 and holding member bulk 62 can be processed to extremely precise dimensions by applying such semiconductor manufacturing technologies as photolithography and etching, resulting in an extremely small, high precision, high performance quartz device.

In addition, while quartz is selected as the material of the holding member in this embodiment, this material shall not be so limited, and in principle any material with a thermal expansion coefficient equal to or nearly equal to the thermal expansion coefficient of the quartz plate can also be used for the material of the holding member as was described in the first embodiment above.

The heat treatment temperature of the direct bonding process above was also described as being 500°C, but the invention shall not be so limited. The adhesion strength was investigated in the temperature ranges of 100 - 350°C, 350 - 500°C, 500 - 570°C, and 570 - 860°C. Because the adhesion strength increases as the heat treatment temperature rises, an appropriate heat treatment temperature within the temperature range retaining the piezoelectric properties of the quartz after heat treatment can be selected.

While a quartz plate measuring 3 mm by 1 mm is used in the above description, it will be obvious that applying the construction of the present invention to smaller quartz devices will obtain quartz devices with higher stability than that of quartz devices manufactured using the conventional holding method.

While the crystal orientation of the quartz plate and holding member has not been discussed above, the thermal expansion coefficients of the quartz plate and holding member will be identical if the crystal axes of these members are precisely aligned, and an ideal frequency-temperature characteristic can be obtained as was described in the first embodiment above.

According to the sixth embodiment described above, it is possible to eliminate the step of treating the polished surfaces to form hydrophilic groups using a solution of ammonia water, hydrogen peroxide, and water which are heated to 60°C, but instead inserting the step of heating the holding member bulk 62 and the quartz wafer 65 in a 5x10⁻⁵ torr vacuum while applying 300 volts between the holding member bulk 62 and the quartz wafer 65. When such a voltage is applied between the holding member bulk 62 and the quartz wafer 65, an electric attractive force caused by the electric charge holds the member bulk 62 and wafer 65 tightly together to effect the direct bonding between the member bulk 62 and wafer 65. For applying 300 volts, the holding member bulk 62 may be held at the ground level and -300 volts may be applied to the quartz wafer 65.

### (Seventh Embodiment)

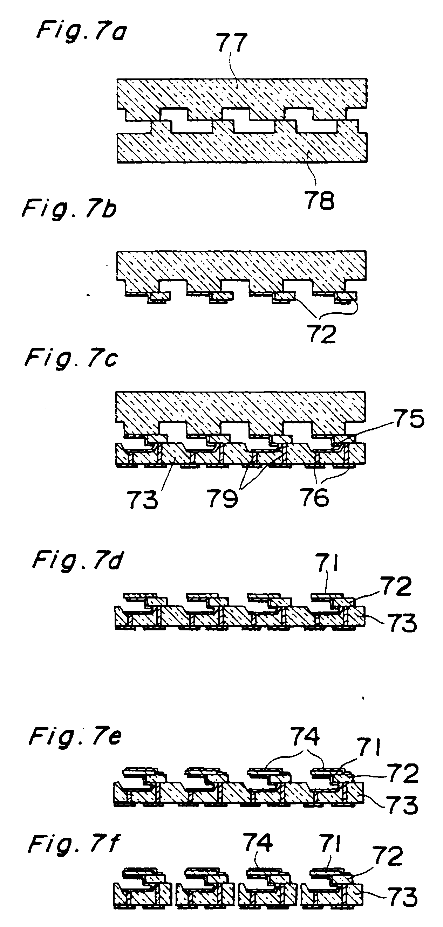

The seventh embodiment according to the present invention is described below with reference to Figs. 7a to 7f, illustrating the steps for manufacturing the quartz device of the third embodiment described above in connection with Fig. 3a. Shown in Figs. 7a to 7f are the quartz plate 71, holding member 72, housing substrate bulk 73, excitation electrode 74, runner electrode 75, terminal 76, quartz wafers 77, 78, and via holes 79. Each of the quartz wafers 77, 78 has plural rectangular projections, and the housing substrate bulk 73 has plural recesses at positions corresponding to the plural rectangular projections. In this embodiment, quartz wafer 78 serves as a holding member bulk.

In this manufacturing method, a 350 µm thick, 3 inch square AT cut quartz wafer is used for the quartz wafers 77, 78, and a 3 inch square, 450 µm thick p-silicon single crystal wafer with a crystal face azimuth of 100 is used for the housing substrate bulk 73.

The one quartz wafer 77 is mechanically lapped and etched to a 50 µm depth leaving plural rectangular projections 3 mm long and 1 mm wide which will be a size equal to the size of the quartz plates 71. The other quartz wafer 78 is similarly mechanically lapped and etched leaving plural rectangular projections which will be a size equal to the size of the holding members 72. The surfaces, particularly the surfaces of the rectangular projections, of the quartz wafers 77, 78 are polished to a mirror finish.

The polished surfaces are then treated to form hydrophilic groups using a solution of ammonia water, hydrogen peroxide, and water which are heated to 60°C, and then water washed. The surfaces are then carefully washed to remove any foreign matter on the rectangular members' contact surfaces which will serve as the quartz plates 71 and holding members 72. The quartz wafers 77, 78 are then placed in contact with each other with the surfaces still in a clean state. While a fairly high adhesion strength is obtained in this state alone, heat treatment at about 500°C is applied to increase the adhesion strength to a level permitting subsequent lapping. This state is shown in Fig. 7a. Here, the positions of the quartz wafers 77, 78 are adjusted so that only a portion of the rectangular projections' surface of quartz wafer 77 contact a portion of the rectangular projections' surface of quartz wafer 78.

The quartz wafer 78, i.e., the holding member bulk, is lapped while holding the quartz wafer 77 to form the holding members 72. Then excitation electrodes 74 and runner electrodes 75 are formed on the quartz wafer 77 and holding members 72 by vacuum vapor deposition of chrome and gold to a thickness of 200 Å and 500 Å, respectively. This is shown in Fig. 7b.

To directly bond the housing substrate bulk 73 with the holding member 72, the upper surface of the housing substrate bulk 73 is polished to a mirror finish. The polished surfaces are then treated to form hydrophilic groups using a solution of ammonia water, hydrogen peroxide, and water which are heated to 60°C, and then water washed. The runner electrodes 75, via holes 79, and terminals 76 are preformed in the housing substrate bulk 73. The surfaces of the housing substrate bulk 73 and the holding members 72 formed on the quartz wafer 77 are then carefully washed to remove any foreign matter. The surfaces of the housing substrate bulk 73 and the holding members 72 formed on the quartz wafer 77 are then contacted with the surfaces still in a clean state. At this point, the holding members 72 and the housing substrate bulk 73 are carefully positioned to make an electric contact between runner electrode 63 and terminal 76 through the electrode provided in the via hole 79.

While a fairly high adhesion strength is obtained in this state alone, heat treatment is applied to increase the adhesion strength to a level permitting subsequent lapping. This state is shown in Fig. 7c. It is to be noted that the heat treatment temperature cannot exceed 870°C for the reason described above. In addition, a sudden temperature difference also cannot be applied because the thermal expansion coefficients of silicon and quartz differ. The heat treatment temperature is thus set at, for example, 500°C in this embodiment.

The quartz wafer 77 held by the holding members 72 directly bonded to the housing substrate bulk 73 is then lapped by holding the housing substrate bulk 73 to separate each of the quartz plates 71. This is shown in Fig. 7d.

The excitation electrodes 74 are formed at approximately the center of the quartz plates 71 on the quartz wafer 77. The runner electrode members are also formed at the same time by vacuum vapor depositions of chrome and gold to a thickness of 200 Å and 500 Å, respectively. This is shown in Fig. 7e.

The housing substrate bulk 73 is cut to produce separate housing substrates, resulting in the quartz device structure described in the third embodiment above. This is shown in Fig. 7f.

The quartz plate 71, holding member 72, and housing substrate bulk 73 can be processed to extremely precise dimensions by applying such semiconductor manufacturing technologies as photolithography and etching, resulting in an extremely small, high precision, high performance quartz device.

In addition, while quartz is selected as the material of the holding member in this embodiment, this material shall not be so limited, and in principle any material with a thermal expansion coefficient equal to or nearly equal to the thermal expansion coefficient of the quartz plate can also be used for the material of the holding member as was described in the first embodiment above. Furthermore, semiconductor is selected as the material of the housing substrate bulk 73 so that it is possible to provide integrated circuits on the housing substrate bulk 73, resulting in quartz devices such as shown in Fig. 3b.

The heat treatment temperature of the direct bonding process above was also described as being 500°C, but the invention shall not be so limited, and other temperature, such as 400°C can be used.

According to the seventh embodiment described above, the step of treating the polished surfaces to form hydrophilic groups using a solution of ammonia water, hydrogen peroxide, and water which are heated to 60°C, is presented immediately before effecting the direct bonding between quartz wafers 77 and 78 and between holding member 72 and housing substrate bulk 73. It is to be noted that each of such a step can be replace by the step of heating the members to be direct bonding in a 5x10⁻⁵ torr vacuum while applying 300 volts between these two members.

For applying 300 volts, the quartz wafer 78 may be held at the ground level and -300 volts may be applied to the quartz wafer 77 in the first instance; and the housing substrate bulk 73 may be held at the ground level and -300 volts may be applied to the holding member 72 in the second instance.

The invention being thus described, it will be obvious that the same may be varied in many ways. Such variations are not to be regarded as a departure from the scope of the invention, and all such modifications as would be obvious to one skilled in the art are intended to be included within the scope of the following claims.

## Claims

1. A quartz device comprising:
a quartz plate made of quartz and having first and second surfaces:
a first excitation electrode deposited on said first surface of said quartz plate;
a second excitation electrode deposited on said second surface of said quartz plate opposing said first excitation electrode; and
a holding member made of a material having a thermal expansion coefficient substantially equal to that of said quartz plate, said holding member having a surface which is held by means of direct bonding to a surface of said quartz plate, said holding member not being a film deposited an another material.

2. A quartz device as claimed in Claim 1, further comprising
a first terminal electrode provided to said holding member and electrically connected to said first excitation electrode; and
a second terminal electrode provided to said holding member and electrically connected to said second excitation electrode.

3. A quartz device as claimed in Claim 1, wherein said holding member is made of quartz.

4. A quartz device as claimed in Claim 1, wherein said holding member is made of glass.

5. A quartz device as claimed in Claim 1, wherein said quartz plate is an AT cut quartz plate.

6. A quartz device as claimed in Claim 1, wherein said quartz plate is a BT cut quartz plate.

7. A quartz device as claimed in Claim 1, wherein said holding member has a recess, and a portion of said quartz plate is connected to said holding member by direct bonding, and a major portion of said quartz plate which is subject to vibration hangs over said recess of said holding member.

8. A quartz device as claimed in Claim 7, further comprising a cover member provided over said holding member.

9. A quartz device as claimed in Claim 1, wherein said holding member is a plate.

10. A quartz device as claimed in Claim 9, further comprising a housing substrate having a recess, a portion of said quartz plate being connected to a portion of said holding member by direct bonding, a portion of said holding member being connected to a portion of said housing substrate by direct bonding, and a major portion of said quartz plate which is subject to vibration hanging over said recess of said housing substrate.

11. A quartz device as claimed in Claim 10, wherein said holding member is made of quartz.

12. A quartz device as claimed in Claim 10, wherein said holding member is made of glass.

13. A quartz device as claimed in Claim 10, wherein said housing substrate is made of glass.

14. A quartz device as claimed in Claim 10, wherein said housing substrate is made of semiconductor.

15. A quartz device as claimed in Claim 14, wherein said housing substrate is further provided with an integrated circuit.

16. A method for making a quartz device as claimed in Claim 1 comprising the steps of:
(a) cleaning said quartz crystal plate and said holding member;
(b) hydrophilically treating the bonding surfaces;
(c) holding and contacting the bonding surfaces together; and
(d) applying a heat treatment.

17. A method for making a quartz device as claimed in Claim 10 comprising the steps of:
(a) cleaning said quartz crystal plate, said holding member (32) and said housing substrate;
(b) hydrophilically treating the bonding surfaces;
(c) holding and contacting the bonding surfaces together; and
(d) applying a heat treatment.

18. A method for making a quartz device as claimed in Claim 1 comprising the steps of:
(a) cleaning said quartz crystal plate and said holding member;
(b) holding and contacting the bonding surfaces together; and
(c) applying a predetermined voltage between said bonding surfaces.

19. A method for making a quartz device as claimed in Claim 10 comprising the steps of:
(a) cleaning said quartz crystal plate, said holding member and said housing substrate;
(b) holding and contacting the bonding surfaces together; and
(c) applying a predetermined voltage between said bonding surfaces.

20. A method for making plural quartz devices as claimed in Claim 7 comprising the steps of:
(a) providing a quartz wafer;
(b) depositing said second excitation electrodes on said quartz wafer;
(c) providing a holding member bulk;
(d) connecting said quartz wafer and said holding member bulk by direct bonding;
(e) lapping said quartz wafer;
(f) depositing said first excitation electrodes on lapped surfaces of said quartz wafer; and
(g) cutting said holding member bulk into individual quartz devices.

21. A method for making plural quartz devices as claimed in Claim 7 comprising the steps of:
(a) providing a quartz wafer with plural rectangular projections;
(b) depositing said second excitation electrodes on surfaces of said rectangular projections;
(c) providing a holding member bulk having plural recesses at positions corresponding to said plural rectangular projections;
(d) deposing said first and second terminal electrodes to said holding member bulk;
(e) connecting said quartz wafer and said holding member bulk by direct bonding effected between a each of said rectangular projections and a portion of portion adjacent each of said recesses;
(f) lapping said quartz wafer to form said quartz plates;
(g) depositing said first excitation electrodes on lapped surfaces of said quartz plates; and
(h) cutting said holding member bulk into individual quartz devices.

22. A method as claimed in Claim 21, wherein said direct bonding is effected by hydrophilically treating the bonding surfaces, holding the bonding surfaces together and applying heat thereafter.

23. A method as claimed in Claim 21, wherein said direct bonding is effected by cleaning the bonding surfaces, holding the bonding surfaces together and applying a predetermined voltage between said bonding surfaces.

24. A method for making plural quartz devices as claimed in Claim 10 comprising the steps of:
(a) providing a quartz wafer;
(b) providing a holding member bulk;
(c) connecting said quartz wafer and said holding member bulk by direct bonding;
(d) lapping said holding member bulk;
(e) depositing said second excitation electrodes on surfaces of said quartz wafer and also on said holding member bulk;
(f) providing a housing substrate bulk;
(g) connecting said holding member bulk and said housing substrate bulk by direct bonding;
(h) lapping said quartz wafer;
(i) depositing said first excitation electrodes on lapped surfaces of said quartz wafer; and
(j) cutting said housing substrate bulk into individual quartz devices.

25. A method for making plural quartz devices as claimed in Claim 10 comprising the steps of:
(a) providing a quartz wafer having plural rectangular projections;
(b) providing a holding member bulk having plural rectangular projections;
(c) connecting said quartz wafer and said holding member bulk by direct bonding effected between a portion of each of said rectangular projections of said quartz wafer and a portion of each of said rectangular projections of said holding member bulk;
(d) lapping said holding member bulk to form said holding members;
(e) depositing said second excitation electrodes on surfaces of said rectangular projections of said quartz wafer and also on said holding members;
(f) providing a housing substrate bulk having plural recesses at positions corresponding to said plural rectangular projections of said quartz wafer;
(g) deposing said first and second terminal electrodes to said housing substrate bulk;
(h) connecting said holding members and said housing substrate bulk by direct bonding effected between a portion of each of said holding members and a portion adjacent each of said recesses;
(i) lapping said quartz wafer to form said quartz plates;
(j) depositing said first excitation electrodes on lapped surfaces of said quartz plates; and
(k) cutting said housing substrate bulk into individual quartz devices.

26. A method as claimed in Claim 25, wherein said direct bonding is effected by hydrophilically treating the bonding surfaces, holding the bonding surfaces together and applying heat thereafter.

27. A method as claimed in Claim 25, wherein said direct bonding is effected by cleaning the bonding surfaces, holding the bonding surfaces together and applying a predetermined voltage between said bonding surfaces.

## Patentansprüche

1. Quarzvorrichtung, enthaltend:
eine aus Quarz hergestellte Quarzplatte, die eine erste sowie eine zweite Oberfläche aufweist;
eine erste Zündelektrode, die auf der ersten Oberfläche der Quarzplatte angeordnet ist;
eine zweite Zündelektrode, die auf der zweiten Oberfläche der Quarzplatte gegenüber der ersten Zündelektrode angeordnet ist; und
ein Halteelement, welches aus einem Material hergestellt ist, das einen thermischen Ausdehnungskoeffizienten aufweist, der im wesentlichen gleich dem der Quarzplatte ist, wobei das Halteelement eine Oberfläche besitzt, die mittels Direktbindung an einer Oberfläche der Quarzplatte gehalten wird, und wobei das Halteelement keine Schicht ist, die an einem anderen Material abgeschieden worden ist.

2. Quarzvorrichtung nach Anspruch 1, weiterhin enthaltend:
eine erste Anschlußelektrode, die an dem Halteelement vorgesehen und elektrisch mit der ersten Zündelektrode verbunden ist; und
eine zweite Anschlußelektrode, die an dem Halteelement vorgesehen und elektrisch mit der zweiten Zündelektrode verbunden ist.

3. Quarzvorrichtung nach Anspruch 1,
bei der das Halteelement aus Quarz hergestellt ist.

4. Quarzvorrichtung nach Anspruch 1,
bei der das Halteelement aus Glas hergestellt ist.

5. Quarzvorrichtung nach Anspruch 1,
bei der die Quarzplatte eine temperaturabhängige Kristallplatte ist.

6. Quarzvorrichtung nach Anspruch 1,
bei der die Quarzplatte eine Quarzplatte mit negativem Temperaturgang ist.

7. Quarzvorrichtung nach Anspruch 1,
bei der das Halteelement eine Ausnehmung aufweist, bei der ein Abschnitt der Quarzplatte mit dem Halteelement durch Direktbindung verbunden ist, und bei der der größere Teil der Quarzplatte, der Schwingungen ausgesetzt ist, über die Ausnehmung des Halteelements ragt.

8. Quarzvorrichtung nach Anspruch 7,
weiterhin enthaltend ein Abdeckelement, welches über dem Halteelement vorgesehen ist.

9. Quarzvorrichtung nach Anspruch 1, bei der das Haltelement eine Platte ist.

10. Quarzvorrichtung nach Anspruch 9,
weiterhin enthaltend ein Gehäusesubstrat, welches eine Ausnehmung aufweist, wobei ein Abschnitt der Quarzplatte mit einem Abschnitt des Halteelements durch Direktbindung verbunden ist, wobei ein Abschnitt des Halteelements mit einem Abschnitt des Gehäusesubstrats durch Direktbindung verbunden ist, und wobei der größere Teil der Quarzplatte, welcher Schwingungen ausgesetzt ist, über die Ausnehmung des Gehäusesubstrats überhängt.

11. Quarzvorrichtung nach Anspruch 10,
bei der das Halteelement aus Quarz hergestellt ist.

12. Quarzvorrichtung nach Anspruch 10,
bei der das Halteelement aus Glas hergestellt ist.

13. Quarzvorrichtung nach Anspruch 10,
bei der das Gehäusesubstrat aus Glas hergestellt ist.

14. Quarzvorrichtung nach Anspruch 10,
bei der das Gehäusesubstrat aus einem Halbleiter hergestellt ist.

15. Quarzvorrichtung nach Anspruch 14,
bei der das Gehäusesubstrat weiterhin mit einer integrierten Schaltung versehen ist.

16. Verfahren zum Herstellen einer Quarzvorrichtung nach Anspruch 1, welches die folgenden Schritte enthält:
(a) Reinigen der Quarzkristallplatte und des Halteelements;
(b) Behandeln der Verbindungsoberflächen, um sie hydrophil zu machen;
(c) Aneinanderhalten der Verbindungsoberflächen; und
(d) Anwenden einer Hitzebehandlung.

17. Verfahren zum Herstellen einer Quarzvorrichtung nach Anspruch 10, welches die folgenden Schritte enthält:
(a) Reinigen der Quarzkristallplatte, des Halteelements und des Gehäusesubstrats;
(b) Behandeln der Verbindungsoberflächen, um sie hydrophil zu machen;
(c) Aneinanderhalten der Verbindungsoberflächen; und
(d) Anwenden einer Hitzebehandlung.

18. Verfahren zum Herstellen einer Quarzvorrichtung nach Anspruch 1, welches die folgenden Schritte enthält:
(a) Reinigen der Quarzkristallplatte und des Halteelements;
(b) Aneinanderhalten der Verbindungsoberflächen; und
(c) Anlegen einer vorbestimmten Spannung zwischen den Verbindungsoberflächen.

19. Verfahren zum Herstellen einer Quarzvorrichtung nach Anspruch 10, welches die folgenden Schritte enthält:
(a) Reinigen der Quarzkristallplatte, des Halteelements und des Gehäusesubstrats;
(b) Aneinanderhalten der Verbindungsoberflächen; und
(c) Anlegen einer vorbestimmten Spannung zwischen den Verbindungsoberflächen.

20. Verfahren zum Herstellen mehrerer Quarzvorrichtungen nach Anspruch 7, welches die folgenden Schritte enthält:
(a) Bereitstellen eines Quarzwafers;
(b) Abscheiden der zweiten Zündelektroden auf dem Quarzwafer;
(c) Bereitstellen eines Halteelementblocks;
(d) Verbinden des Quarzwafers mit dem Halteelementblock durch Direktbindung;
(e) Läppen des Quarzwafers;
(f) Abscheiden der ersten Zündelektroden auf den geläppten Oberflächen des Quarzwafers; und
(g) Zerschneiden des Halteelementblocks in einzelne Quarzvorrich4ungen.

21. Verfahren zum Herstellen mehrerer Quarzvorrichtungen nach Anspruch 7, welches die folgenden Schritte enthält:
(a) Bereitstellen eines Quarzwafers mit mehreren rechteckförmigen Vorsprüngen;
(b) Abscheiden der zweiten Zündelektroden auf Oberflächen der rechteckförmigen Vorsprünge;
(c) Bereitstellen eines Blocks von Halteelementen, welche mehrere Ausnehmungen an Positionen aufweisen, die den mehreren rechteckförmigen Vorsprüngen entsprechen;
(d) Abscheiden der ersten und der zweiten Anschlußelektroden auf dem Halteelementblock;
(e) Verbinden des Quarzwafers mit dem Halteelementblock durch Direktbindung zwischen jeweils einem Abschnitt der rechteckförmigen Vorsprünge und jeweils einem Abschnitt benachbart zu den Ausnehmungen;
(f) Läppen des Quarzwafers, um die Quarzplatten zu bilden;
(g) Abscheiden der ersten Zündelektroden auf den geläppten Oberflächen der Quarzplatten; und
(h) Zerschneiden des Halteelementblocks in einzelne Quarzvorrichtungen.

22. Verfahren nach Anspruch 21,
bei dem die Direktbindung durch Hydrophilmachen der Verbindungsoberflächen, durch Aneinanderhalten der Verbindungsoberflächen und durch anschließendes Erwärmen durchgeführt wird.

23. Verfahren nach Anspruch 21,
bei dem die Direktbindung durch Reinigen der Verbindungsoberflächen, durch Aneinanderhalten der Verbindungsoberflächen und durch Anlegen einer vorbestimmten Spannung zwischen den Verbindungsoberflächen erfolgt.

24. Verfahren zum Herstellen mehrerer Quarzvorrichtung nach Anspruch 10, welches die folgenden Schritte enthält:
(a) Bereitstellen eines Quarzwafers;
(b) Bereitstellen eines Halteelementblocks;
(c) Verbinden des Quarzwafers mit dem Halteelementblock durch Direktbindung;
(d) Läppen des Halteelementblocks;
(e) Abscheiden der zweiten Zündelektroden auf Oberflächen des Quarzwafers und auf dem Halteelementblock;
(f) Bereitstellen eines Gehäusesubstratblocks;
(g) Verbinden des Halteleementblocks mit dem Gehäusesubstratblock durch Direktbindung;
(h) Läppen des Quarzwafers;
(i) Abscheiden der ersten Zündelektroden auf den geläppten Oberflächen des Quarzwafers; und
(j) Zerschneiden des Gehäusesubstratblocks in einzelne Quarzvorrichtungen.

25. Verfahren zum Herstellen mehrere Quarzvorrichtungen nach Anspruch 10, welches die folgenden Schritte enthält:
(a) Bereitstellen eines Quarzwafers, welcher mehrere rechteckförmige Vorsprünge aufweist;
(b) Vorsehen eines Blocks von Halteelementen, welche mehrere rechteckförmige Vorsprünge aufweisen;
(c) Verbinden des Quarzwafers mit dem Halteelementblock durch Direktbindung, welche jeweils zwischen einem Abschnitt der rechteckfömigen Vorsprünge des Quarzwafers und einem Abschnitt der rechteckförmigen Vorsprünge des Halteelementblocks erfolgt;
(d) Läppen des Halteelementblocks, um die Halteelemente zu bilden;
(e) Abscheiden der zweiten Zündelektroden auf Oberflächen der rechteckförmigen Vorsprünge des Quarzwafers und der Halteelemente;
(f) Bereitstellen eines Blocks von Gehäusesubstraten, welche mehrere Ausnehmungen in Positionen aufweisen, die den mehreren rechteckförmigen Vorsprüngen des Quarzwafers entsprechen;
(g) Abscheiden der ersten und zweiten Anschlußelektroden auf dem Gehäusesubstratblock;
(h) Verbinden des Halteelementblocks und des Gehäusesubstratblocks durch Direktbindung, welche jeweils zwischen einem Abschnitt der einzelnen Halteelemente und einem Abschnitt benachbart zu jeder der Ausnehmungen erfolgt;
(i) Läppen des Quarzwafers, um die Quarzplatten zu bilden;
(j) Abscheiden der ersten Zündelektroden auf den geläppten Oberflächen der Quarzplatten; und
(k) Zerschneiden des Gehäusesubstratblocks in einzelne Quarzvorrichtungen.

26. Verfahren nach Anspruch 25,
bei dem die Direktbindung durch Hydrophilmachen der Verbindungsoberflächen, das Aneinanderhalten der Verbindungsoberflächen und durch anschließendes Erwärmen ausgeführt wird.

27. Verfahren nach Anspruch 25,
bei dem die Direktverbindung durch Reinigen der Verbindungsoberflächen, Aneinanderhalten der Verbindungsoberflächen und Anlegen einer vorbestimmten Spannung zwischen den Verbindungsoberflächen erfolgt.

## Revendications

1. Un dispositif à quartz comportant :
une plaque de quartz faite de quartz et comportant des première et seconde surfaces;
une première électrode d'excitation déposée sur ladite première surface de ladite plaque de quartz;
une seconde électrode d'excitation disposée sur ladite seconde surface de ladite plaque de quartz opposée à ladite première électrode d'excitation; et
un élément de support fait d'un matériau comportant un coefficient de dilatation thermique essentiellement égal à celui de ladite plaque de quartz, ledit élément de support comportant une surface qui est maintenue au moyen d'une liaison directe à une surface de ladite plaque de quartz, ledit élément de support n'étant pas un film déposé sur un autre matériau.

2. Un dispositif à quartz selon la revendication 1, comportant en outre
une première électrode terminale prévue sur ledit élément de support et connectée de manière électrique à ladite première électrode d'excitation; et
une seconde électrode terminale prévue sur ledit élément de support et connectée électriquement à ladite seconde électrode d'excitation.

3. Un dispositif à quartz selon la revendication 1, dans lequel ledit élément de support est fait de quartz.

4. Un dispositif à quartz selon la revendication 1, dans lequel ledit élément de support est fait de verre.

5. Un dispositif à quartz selon la revendication 1, dans lequel ladite plaque de quartz est une plaque de quartz coupée en AT.

6. Un dispositif à quartz selon la revendication 1, dans lequel ladite plaque de quartz est une plaque de quartz coupée en BT.

7. Un dispositif à quartz selon la revendication 1, dans lequel ledit élément de support comporte un renfoncement, et une partie de ladite plaque de quartz est connectée audit élément de support par une liaison directe, et une partie principale de ladite plaque de quartz qui est sujette à des vibrations s'étend au-dessus dudit renfoncement dudit élément de support.

8. Un dispositif à quartz selon la revendication 7, comportant en outre un élément de recouvrement prévu sur ledit élément de support.

9. Un dispositif à quartz selon la revendication 1, dans lequel ledit élément de support est une plaque.

10. Un dispositif à quartz selon la revendication 9, comportant en outre un substrat de réception comportant un renfoncement, une partie de ladite plaque de quartz étant connectée à une partie dudit élément de support par une liaison directe, une partie dudit élément de support étant connectée à une partie dudit substrat de réception par une liaison directe, et une partie principale de ladite plaque de quartz qui est sujette à des vibrations s'étendant par dessus ledit renfoncement dudit substrat de réception.

11. Un dispositif à quartz selon la revendication 10, dans lequel ledit élément de support est fait de quartz.

12. Un dispositif à quartz selon la revendication 10, dans lequel ledit élément de support est fait de verre.

13. Un dispositif à quartz selon la revendication 10, dans lequel ledit substrat de réception est fait de verre.

14. Un dispositif à quartz selon la revendication 10, dans lequel ledit substrat de réception est fait de semiconducteur.

15. Un dispositif à quartz selon la revendication 14, dans lequel ledit substrat de réception est prévu en outre avec un circuit intégré.

16. Une méthode pour la fabrication d'un dispositif à quartz selon la revendication 1 comportant les étapes de :
(a)nettoyage de ladite plaque de cristal de quartz et dudit élément de support;
(b) traitement de manière -hydrophile des surfaces de liaison;
(c)maintien et mise en contact des surfaces de laison ensemble; et
(d) application d'un traitement de chauffage.

17. Une méthode pour la fabrication d'un dispositif à quartz selon la revendication 10 comportant les étapes de :
(a) nettoyage de ladite plaque de cristal de quartz, dudit élément de support et dudit substrat de réception;
(b) traitement de manière hydrophile des surfaces de liaison;
(c)maintien et mise en contact des surfaces de liaison ensemble; et
(d) application d'un traitement de chauffage.

18. Une méthode pour fabriquer un dispositif à quartz selon la revendication 1, comportant les étapes de :
(a) nettoyage de ladite plaque de cristal de quartz et dudit élément de support;
(b) maintien et mise en contact des surfaces de liaison ensemble; et
(c) application d'une tension prédéterminée entre lesdites surfaces de liaison.

19. Une méthode pour la fabrication d'un dispositif à quartz selon la revendication 10 comportant les étapes de :
(a) nettoyage de ladite plaque de cristal de quartz, dudit élément de support et dudit substrat de réception;
(b) maintien et mise en contact des surfaces de liaison ensemble, et
(c) application d'une tension prédéterminée entre lesdites surfaces de liaison.

20. Une méthode pour la fabrication d'une pluralité de dispositifs à quartz selon la revendication 7 comprenant les étapes de :
(a) fourniture d'une plaquette de quartz;
(b) déposition desdites secondes électrodes d'excitation sur ladite plaquette de quartz;
(c)fourniture d'un volume d'élément de support;
(d) connexion de ladite plaquette de quartz et dudit volume d'élément de support par une liaison directe;
(e) recouvrement de ladite plaquette de quartz;
(f) déposition desdites premières électrodes d'excitation sur les surfaces recouvertes de ladite plaquette de quartz; et
(g) découpe dudit -volume d'élément de support en dispositifs à quartz individuels.

21. Une méthode pour la fabrication d'une pluralité de dispositifs à quartz selon la revendication 7 comportant les étapes de :
(a) fourniture d'une plaquette de quartz avec plusieurs projections rectangulaires;
(b) déposition desdites secondes électrodes d'excitation sur les surfaces desdites projections rectangulaires;
(c) fourniture d'un volume d'élément de support comportant une pluralité de renfoncements à des positions correspondant à ladite pluralité de projections rectangulaires;
(d) déposition desdites première et seconde électrodes terminales sur ledit volume d'éléments de support;
(e) connexion de ladite plaquette de quartz et dudit volume d'élément de support par liaison directe réalisée entre une partie de chacune desdites projections rectangulaires et une partie adjacente de chacun desdits renfoncements;
(f) recouvrement de ladite plaquette de quartz pour former lesdites plaques de quartz;
(g) déposition desdites premières électrodes d'excitation sur les surfaces recouvertes desdites plaques de quartz; et
(h) découpe dudit volume d'élément de support en dispositifs à quartz individuels.

22. Une méthode selon la revendication 21, dans laquelle ladite liaison directe est réalisée par un traitement de manière hydrophile des surfaces de liaison, par le maintien des surfaces de liaison ensemble et l'application par la suite d'un chauffage.

23. Une méthode selon la revendication 21, dans laquelle ladite liaison directe est réalisée par le nettoyage des surfaces de liaison, le maintien des surfaces de liaison ensemble et l'application d'une tension prédéterminée entre lesdites surfaces de liaison.

24. Une méthode pour la fabrication d'une pluralité de dispositifs à quartz selon la revendication 10 comportant les étapes de :
(a) fourniture d'une plaquette de quartz;
(b) fourniture d'un volume d'élément de support;
(c)connexion de ladite plaquette de quartz et dudit volume d'élément de support par liaison directe;
(d) recouvrement dudit volume d'élément de support;
(e) déposition desdites secondes électrodes d'excitation sur des surfaces de ladite plaquette de quartz et aussi sur ledit volume d'élément de support;
(f) fourniture d'un volume de substrat de réception;
(g) connexion dudit volume d'élément de support et dudit volume de substrat de réception par liaison directe;
(h) recouvrement de ladite plaquette de quartz;
(i) déposition desdites premières électrodes d'excitation sur des surfaces recouvertes de ladite plaquette de quartz;
(j) découpe dudit volume de substrat de réception en dispositifs à quartz individuels.

25. Une méthode pour la fabrication d'une pluralité de dispositifs à quartz selon la revendication 10 comportant les étapes de :
(a) fourniture d'une plaquette de quartz comportant une pluralité de projections rectangulaires;
(b) fourniture d'un volume d'élément de support comportant une pluralité de projections rectangulaires;
(c)connexion de ladite plaquette de quartz et dudit volume d'élément de support par liaison directe réalisée entre une partie de chacune desdites projections rectangulaires de ladite plaquette de quartz et une partie de chacune desdites projections rectangulaires dudit volume d'élément de support;
(d) recouvrement dudit volume d'élément de support pour former lesdits éléments de support;
(e) déposition desdites secondes électrodes d'excitation sur des surfaces desdites projections rectangulaires de ladite plaquette de quartz et aussi sur lesdits éléments de support;
(f) fourniture d'un volume de substrat de réception comportant une pluralité de renfoncement à des positions correspondant à ladite pluralité de projections rectangulaires de ladite plaquette de quartz;
(g) déposition desdites première et seconde électrodes terminales sur ledit volume de substrat de réception;
(h) connexion desdits éléments de support et dudit volume de substrat de réception par liaison directe réalisée entre une partie de chacun desdits éléments de support et une partie adjacente de chacun desdits renfoncements;
(i) recouvrement de ladite plaquette de quartz pour former lesdites plaques de quartz;
(j) déposition desdites premières électrodes d'excitation sur des surfaces recouvertes desdites plaques de quartz; et
(k) découpe dudit volume de substrat de réception en dispositifs à quartz individuels.

26. Une méthode selon la revendication 25, dans laquelle ladite liaison directe est réalisée par un traitement de manière hydrophile des surfaces de liaison, par le maintien des surfaces de liaison ensemble et l'application par la suite d'un chauffage.

27. Un méthode selon la revendication 25, dans laquelle ladite liaison directe est effectuée par le nettoyage des surfaces de liaison, le maintien des surfaces de liaison ensemble et l'application d'une tension prédéterminée entre lesdites surfaces de liaison.
